(19) Europäisches Patentamt
European Patent Office
Office européen des brevets

(11) Veröffentlichungsnummer: **0 034 274**
**A2**

# (12) EUROPÄISCHE PATENTANMELDUNG

(21) Anmeldenummer: **81100587.5**

(51) Int. Cl.³: **H 01 B 1/12**

(22) Anmeldetag: **28.01.81**

(30) Priorität: **13.02.80 DE 3005299**

(43) Veröffentlichungstag der Anmeldung:
**26.08.81 Patentblatt 81/34**

(84) Benannte Vertragsstaaten:
**AT BE CH DE FR GB LI NL**

(71) Anmelder: **BASF Aktiengesellschaft**
**Carl-Bosch-Strasse 38**
**D-6700 Ludwigshafen(DE)**

(72) Erfinder: **Naarmann, Herbert, Dr.**
**Haardtblick 15**
**D-6719 Wattenheim(DE)**

(72) Erfinder: **Penzien, Klaus, Dr.**
**Bensheimer Ring 18**
**D-6710 Frankenthal(DE)**

## (54) Verfahren zur Herstellung elektrisch leitfähiger Polyaromaten und deren Verwendung in der Elektrotechnik und zur antistatischen Ausrüstung von Kunststoffen.

(57) Die Erfindung betrifft ein Verfahren zur Herstellung von elektrisch leitfähigen Polyaromaten mit elektrischen Leitfähigkeitswerten größer als $10_0^2$S/cm, wobei man Polyaromaten unter Ausschluß von Wasserfeuchtigkeit und von Sauerstoff 0,5 bis 5 Gewichtsprozent einer starken Lewis-Säure mit $pk_s$-Werten von - 10 bis +4, vorzugsweise die Verbindung $AsF_5$, $SbF_5$, $HClO_4$, $NO^+SbF_6^-$, $NO^+AsF_6^-$, $NO^+PF_6^-$, $NO_2^+PF_6^-$, $NO^+BF_4^-$, $NO_2^+ClO_4^-$, $(CF_3)_2SO_4$, 2, 4, 6-Trinitrophenol, 2,4,6-Trinitrophenylsulfosäure oder 2, 4, 6-Trinitrophenylcarbonsäure, zusetzt.

Die hergestellten, leitfähigen Polyaromaten können in der Elektrotechnik zur Herstellung von Sonnenzellen, zur Umwandlung und Fixierung von Strahlung, zur Herstellung elektrischer und magnetischer Schalter und zur antistatischen Ausrüstung von Kunststoffen verwendet werden.

EP 0 034 274 A2

Croydon Printing Company Ltd.

Verfahren zur Herstellung elektrisch leitfähiger Polyaromaten und deren Verwendung in der Elektrotechnik und zur antistatischen Ausrüstung von Kunststoffen

Die Erfindung betrifft ein Verfahren zur Herstellung von elektrisch leitfähigen Polyaromaten mit elektrischen Leitfähigkeitswerten größer als $10^{-2}$ S/cm und deren Verwendung in der Elektroindustrie zur Herstellung von Sonnenzellen, zur Umwandlung und Fixierung von Strahlung und zur Herstellung elektrischer und magnetischer Schalter sowie zur antistatischen Ausrüstung von Kunststoffen.

Es ist bereits bekannt, Polyphenylene durch oxidative Kupplung entsprechend der Literatur: "Macromolecular Syntheses Collective", Vol. 1, (1979) Seiten 109 bis 110, Verlag John Wiley & Sons und "Naturwissenschaften" 56 (1969) Seiten 308 bis 313 herzustellen. Außerdem ist die Herstellung von Polyphenylenen durch stufenweise Polykondensation nach R. Gehm und W. Kern aus "Makromolekulare Chemie" 7 (1951) Seiten 46 bis 61 bekannt, wobei besonders einheitliche para-verkettete methylsubstituierte Derivate erhalten werden, die nicht zusätzlich durch ortho- oder meta-verknüpfte Polymere verunreinigt sind.

Der Erfindung lag die Aufgabe zugrunde, die an sich bekannten Effekte bei den Polyphenylenen, die stäbchenförmig entsprechend der Formel

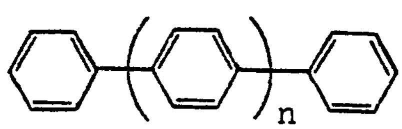

angeordnet sind, auf Polyaromaten mit kondensierten bzw. anellierten durchkondensierten $\pi$-Systemen zu übertragen.

Fre/BL

Diese Aufgabe wird erfindungsgemäß dadurch gelöst, daß man den Polyaromaten unter Ausschluß von Wasserfeuchtigkeit und von Sauerstoff, 0,5 bis 5 Gewichtsprozent, bezogen auf den eingesetzten Polyaromaten, eine starke Lewis-Säure mit $pk_s$-Werten von -10 bis +4 zusetzt. Nach bevorzugter Verfahrensweise wird als Lewis-Säure die Verbindung $AsF_5$, $SbF_5$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-Trinitrophenol, 2,4,6-Trinitrophenylsulfonsäure oder 2,4,6-Trinitrophenylcarbonsäure zugesetzt.

Unter Polyaromaten werden höhermolekulare Produkte verstanden, die nicht linear aufgebaut sind - entsprechend den in para-Stellung verknüpften Polyphenylenen - sondern sog. polycyclische aromatische Kohlenwasserstoffe sind und anellierte Benzolkerne enthalten - entsprechen den Angaben E. Klav "Aromatische Kohlenwasserstoffe" II. Auflage 1952, Springer Verlag, Heidelberg S. VI-XX und mehr als zwei Benzolkerne in polycyclischen System enthalten und Molgewichte zwischen 300 und 3000, vorzugsweise zwischen 400 und 1500 enthalten.

Bevorzugte polycyclische Kohlenstoffe sind: Tetraphenylen, 1,2,7,8-Dibenzperylen, Bianthen, 3,4,8,9-Dibenzpyren, Terylen, Peropyren, Anthanthren, Zethren, Fluoranthen, 11,12 peri Naphthylen fluoranthen, Dekacyclen, Naphtho[2',7',1,8]-anthren, Dihydrotriangutren.

Die Synthese der oben aufgeführten polycyclischen Kohlenwasserstoffe ist in dem cit. Buch von E. Clav angegeben.

Die elektrischen Leitfähigkeitswerte werden in S/cm bei 30°C gemessen, die Messung selbst erfolgt nach der Methode von F. Beck, Berichte Bunsengesellschaft, Physikalische Chemie 68 (1964) Seiten 558 bis 567. Die elektrischen Leit-

fähigkeitswerte der erfindungsgemäßen leitfähigen Polyaromaten ist größer als $10^{-2}$S/cm.
Nach dem erfindungsgemäßen Verfahren wird den Polyaromaten unter Ausschluß von Wasserfeuchtigkeit und von Sauerstoff 0,5 bis 5 Gewichtsprozent, bezogen auf das eingesetzte Polyphenylen, eine starke Lewis-Säure mit $pk_s$-Werten von -10 bis +4 zugesetzt.

Das Einarbeiten der Zusätze erfolgt unter Ausschluß von Feuchtigkeit (Wasser) sowie Sauerstoff (Luft), es wird daher vorzugsweise unter Edelgas-Argonatmosphäre gearbeitet. Gegebenenfalls werden Hilfsflüssigkeiten wie Tetrahydrofuran, Dimethoxyglykol, Nitromethan oder Methylenchlorid eingesetzt, die nach dem Einarbeiten bei Temperaturen unter 30°C in Vakuum abgezogen werden.

Durch die genannten Zusätze können elektrische Leitfähigkeitsanstiege von einigen Größenordnungen erreicht werden. Die Ausgangsleitfähigkeiten der Polyaromaten betrugen ca. $10^{-12}$, sie liefern aber nach der Zugabe der erfindungsgemäßen Zusätze Leitfähigkeiten größer als $10^{-2}$S/cm.

Die erfindungsgemäß hergestellten elektrisch leitfähigen Polyaromaten mit elektrischen Leitfähigkeiten größer als $10^{-2}$S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter geeignet. Durch die Zusätze der starken Lewis-Säure zum Polyaromaten entstehen sog. p-Leiter (vgl. J. Chem. Education, Vol. 46, Nr. 2, Seite 82 [1969]).

Die in den folgenden Beispielen genannten Teile sind Gewichtsteile bei den Ausgangskohlenwasserstoffen und Mol.% bei den jeweiligen Zusatzstoffen.

Beispiele 1 bis 7

10 Teile eines Polyaromaten werden unter Argonatmosphäre und Ausschluß von Feuchtigkeit mit dem jeweiligen Zusatzstoff versetzt, die Messung der elektr. Leitfähigkeit erfolgt nach F. Beck. Ber. Bunsengesellschaft, Phys. Chem. 68, 558 - 567 (1964).

| Nr. | Polyaromat Typ und Menge | Zusatzstoff Art und Menge (Mol.%) | | Leitfähigkeit S/cm 30°C vor dem Zusatz | nach dem Zusatz |
|---|---|---|---|---|---|
| 1a | 1 Teil Tetraphenylen | $AsF_5$ | 0,1 | $10^{-13}$ | $1{,}4 \cdot 10^{-2}$ |
| 1 | 1 Teil " | $AsF_5$ | 0, | $10^{-13}$ | $2{,}9 \cdot 10^{-2}$ |
| 2 | 1 Teil Bianthen | $SbF_5$ | 0,1 | $10^{-13}$ | $4{,}1 \cdot 10^{-2}$ |
| 3 | 1 Teil Bianthen | $HClO_4$ | 0,1 | $10^{-13}$ | $3{,}8 \cdot 10^{-2}$ |
| 4 | 1 Teil Peropyren | $HClO_4$ | 0,1 | | |
| 5 | 1 Teil Zethren | 2,4,6-Trinitro-[x] phenylsulfosäure | | $10^{-13}$ | $2{,}6 \cdot 10^{-1}$ |
| 6 | 1 Teil Terylen | " | 0,1 | $10^{-13}$ | $7{,}8 \cdot 10^{-1}$ |
| 7 | 1 Teil " | $NO^+SbF_6$ | 0,05 | $10^{-13}$ | $1{,}5 \cdot 10^{+1}$ |

+) bedeutet: Zusatzstoff 0,1

## Patentansprüche

1. Verfahren zur Herstellung von elektrisch leitfähigen Polyaromaten mit elektrischen Leitfähigkeitswerten größer als $10^{-2}$ S/cm, dadurch gekennzeichnet, daß den Polyaromaten unter Ausschluß von Wasserfeuchtigkeit und von Sauerstoff 0,5 bis 5 Gewichtsprozent, bezogen auf den eingesetzten Polyaromaten, eine starke Lewis-Säure mit $pk_s$-Werten von -10 bis +4 zugesetzt wird.

2. Verfahren nach Anspruch 1, dadurch gekennzeichnet, daß als Lewis-Säure die Verbindung $AsF_5$, $SbF_5$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-Trinitrophenol, 2,4,6-Trinitrophenylsulfosäure oder 2,4,6-Trinitrophenylcarbonsäure zugesetzt wird.

3. Verwendung der nach Anspruch 1 hergestellten, leitfähigen Polyaromaten in der Elektrotechnik zur Herstellung von Sonnenzellen, zur Umwandlung und Fixierung von Strahlung und zur Herstellung elektrischer und magnetischer Schalter.

4. Verwendung der nach Anspruch 1 hergestellten leitfähigen Polyaromaten zur antistatischen Ausrüstung von Kunststoffen.